# EUROPEAN PATENT SPECIFICATION

(11) **EP 4 567 553 B1**
(45) Date of publication and mention of the grant of the patent: **20.05.2026**
(21) Application number: 24211758.8
(22) Date of filing: 08.11.2024
(51) Int. Cl.: G06F 1/16, B65D 43/02, H04M 1/02, H05K 5/03, B65D 85/00

(54) **COVER AND ELECTRONIC DEVICE**
ABDECKUNG UND ELEKTRONISCHE VORRICHTUNG
COUVERCLE ET DISPOSITIF ÉLECTRONIQUE

(30) Priority: 30.11.2023 JP 2023202705
(43) Date of publication of application: 11.06.2025
(73) Proprietor: CASIO COMPUTER CO., LTD., Tokyo 151-8543 (JP)
(72) Inventor: Eguchi, Hiroki, Hamura-shi, Tokyo, 205-8555 (JP); Yuki, Koji, Hamura-shi, Tokyo, 205-8555 (JP); Tozuka, Takumi, Hamura-shi, Tokyo, 205-8555 (JP)
(74) Representative: Grünecker Patent- und Rechtsanwälte PartG mbB

(56) References cited:
- JP-A- H08 255 604
- JP-U- S5 234 041
- JP-Y2- H0 238 370
- US-A1- 2007 159 133
- US-B2- 8 212 708

## Description

### TECHNICAL FIELD

The present invention relates to a cover and an electronic device.

### DESCRIPTION OF RELATED ART

A known cover structure is configured to lock a cover to a case by a hook structure (for example, see JP S52 34041 U) .

According to JP S52 34041 U, the cover structure has a shallow and narrow groove on which a finger is placed to release the lock between the case and the cover. Such a groove makes it difficult to release the lock between the case and the cover.

US 2007/159133 A1 discloses a battery charger having a housing with a front battery compartment closed by a hinged door. The door is latched to the housing and carries a finger-actuated tab which is concavely recessed toward the door surface, allowing the user to press the tab to release the latch and open the door for battery access.

The present invention has been conceived in view of the above and is aimed to make it easier to unlock the engagement between a casing and a cover.

### SUMMARY OF THE INVENTION

To solve the above problem, there is provided a cover formed to cover and uncover an opening of a casing, the cover comprising a hook formed to engage the cover with the casing, wherein the hook includes a finger-putting part that is moved in a direction of loosening an engagement between the cover and the casing to uncover the opening, the finger-putting part has a curved shape depressed in the direction of loosening the engagement, the hook includes a base part protruding from a back surface side of the cover, a manipulation part that faces the base part and includes the finger-putting part and an engaging part, the engaging part being formed to engage with an engaging target part of the casing, and a connecting part that connects the base part and the manipulation part, the base part, the manipulation part, the engaging part, and the connecting part have a curved shape depressed in the direction of loosening the engagement so as to correspond to the curved shape of the finger-putting part, the hook is a plate spring hook, and both ends of the connecting part in a width direction are chamfered.

### Advantageous Effects of Invention

According to the present invention, the engagement between a case and a cover can be easily released.

### BRIEF DESCRIPTION OF DRAWINGS

The accompanying drawings are not intended as a definition of the limits of the invention but illustrate embodiments of the invention, and together with the general description given above and the detailed description of the embodiments given below, serve to explain the principles of the invention, wherein:
FIG. 1 is a plan view of the back surface of a scientific calculator as an embodiment of an electronic device to which the present invention is applied;
FIG. 2 is a perspective view of the lower part of the back surface of the scientific calculator;
FIG. 3 is a plan view of the cover viewed from the front;
FIG. 4 is an enlarged lateral view of a part of the cover including a hook;
FIG. 5 is a cross-sectional view along the A-A line in FIG.1;
FIG. 6A is an enlarged view of the area enclosed by the dashed line in FIG.5;
FIG.6B shows a state where a finger-putting part is moved in a direction of bringing a manipulation part closer to a base part from the state shown in FIG.6A;
FIG.7 shows a state where an engaging part is engaged with an engaging target part; and
FIG.8 is a cross-sectional view along the A-A line in FIG.1 in a state the opening is uncovered.

### DETAILED DESCRIPTION

Hereinafter, an embodiment of a cover and an electronic device of the present disclosure is described with reference to the figures. In the following embodiment, a scientific calculator is used as an example of an electronic device to which the present disclosure is applied. However, the electronic device is not limited to a scientific calculator. The present disclosure is applicable to any electronic device (e.g., an electronic dictionary or a tablet terminal) that is provided with a cover 20 configured to cover an opening 11 of a casing 10, which are described later.

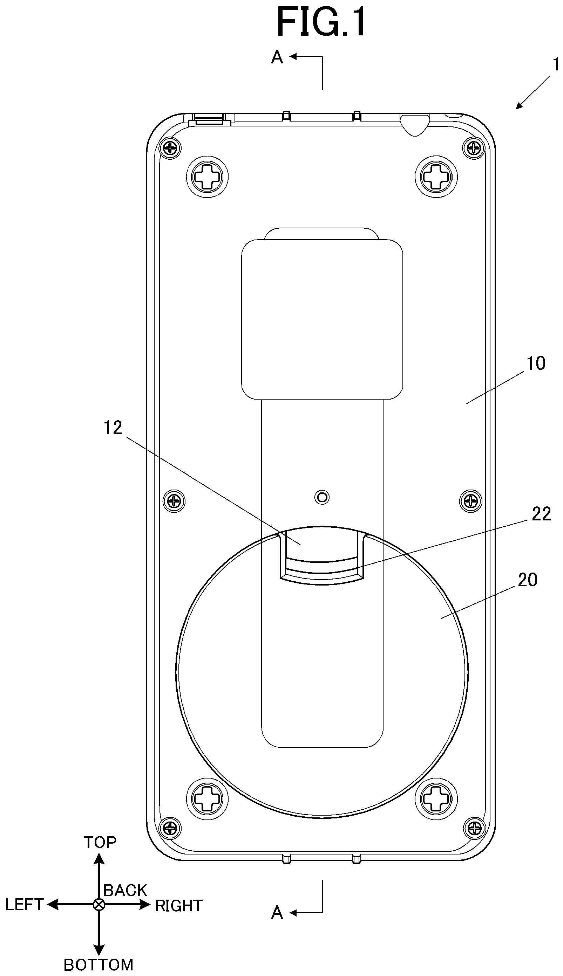

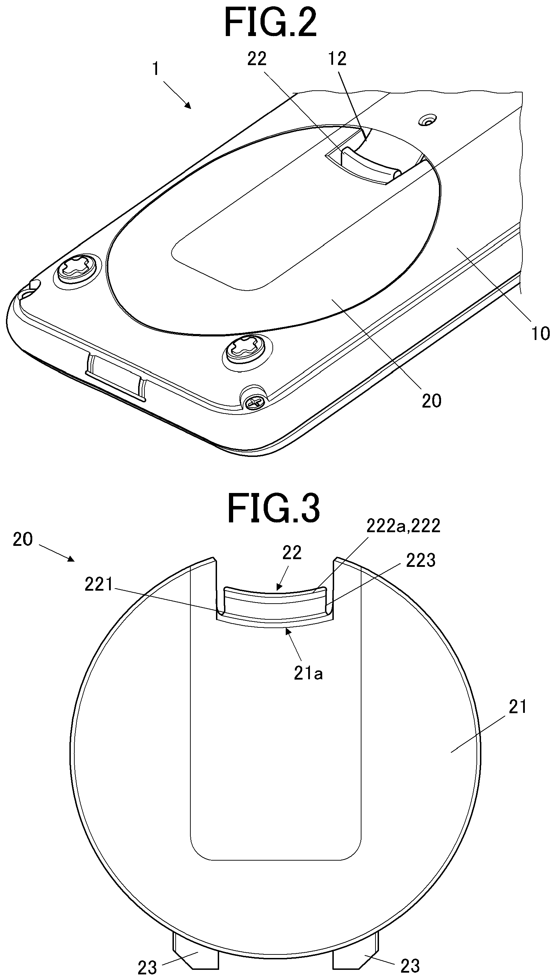

As shown in FIG.1 and FIG.2, the scientific calculator 1 includes a casing 10 and a cover (cover body) 20. FIG. 1 shows the top-bottom direction, the left-right direction, and the front-back direction that are perpendicular to each other. The front-back direction corresponds to the thickness direction of the casing 10.

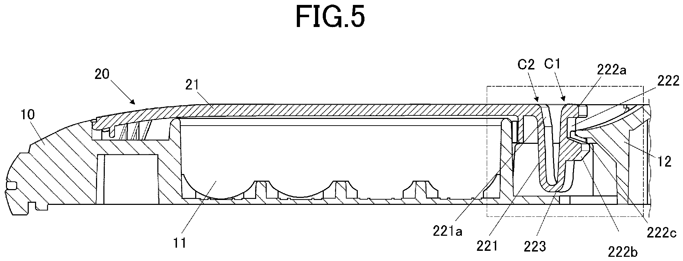

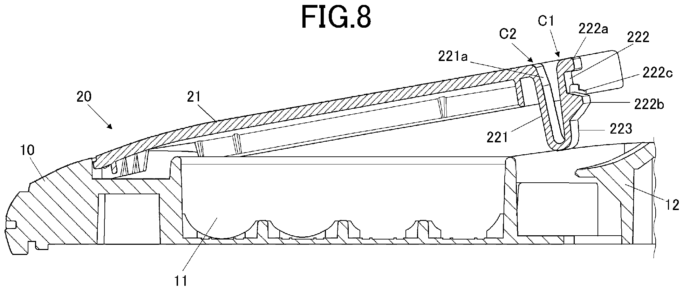

On the back of the casing 10, an opening 11 is formed to house (load) not-illustrated four dry cell batteries or not-illustrated dry-cell-type secondary batteries (see FIG.5 and FIG.8).

The opening 11 has a round shape corresponding to the external round shape of the cover 20 (see FIG.3). By attaching the cover 20, the opening 11 is covered.

As shown in FIG.1 and FIG.5, an engaging target part (engaging target region) 12 is provided at a specific position of the opening 11 corresponding to a hook 22 (described later) of the cover 20. The engaging target part 12 is engaged with the hook 22 when the cover 20 is attached.

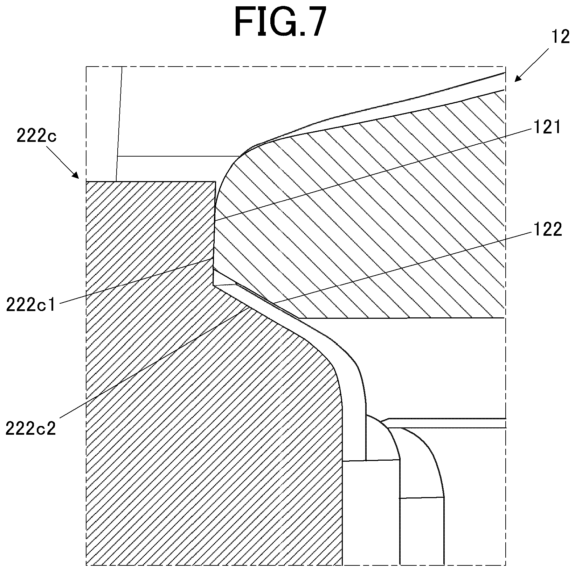

The engaging target part 12 is formed like an eave that projects from the edge of the opening 11 toward the center of the opening 11 while sloping downward. As shown in FIG.7, the engaging target part 12 includes an engaging target surface 121. The engaging target surface 121 is formed to be engaged with an engaging surface 222c1 of each rib 222c formed on the hook 22. The ribs 222c are described later. The engaging target part 12 has a sloping surface (first surface) 122 adjacent to the engaging target surface 121. When the engaging target surface 121 is engaged with the engaging surface 222c1 of each rib 222c (described later), namely when the cover 20 is attached to the casing 10, the sloping surface 122 faces the sloping surfaces (second surfaces) 222c2 of the ribs 222c with a predetermined distance from the sloping surfaces 222c2. The predetermined distance is determined so as to prevent rattling, which is caused by an impact on the cover 20 or the casing 10. Thus, rattling caused by an impact on the cover 20 or the casing 10 can be appropriately prevented.

At predetermined positions of the opening 11 (the positions corresponding to locking parts 23 of the cover 20, which are described later), locking holes are formed although not illustrated. The locking parts 23 are locked (inserted) to the locking holes when the cover 20 is attached.

As shown in FIG.3, the cover 20 includes a cover body 21, the hook (elastic member) 22, and the locking parts 23.

The cover body 21 is for covering the opening 11 of the casing 10. The cover body 21 has a round shape (disk shape) corresponding to the round-shaped opening 11. Part of the cover body 21 corresponding to the engaging target part 12 of the casing 10 is notched. The hook 22 is formed at the inner end 21a of the notch.

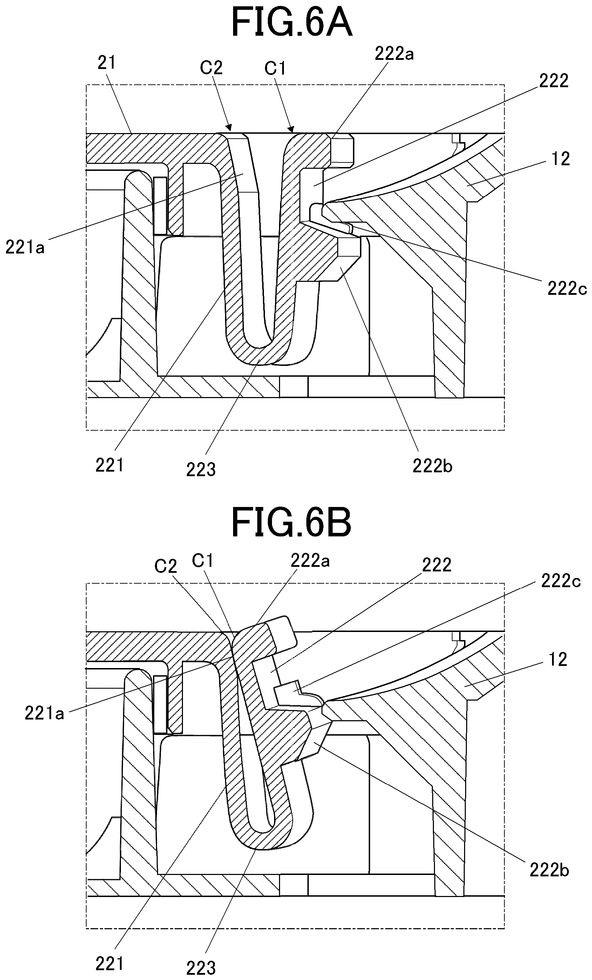

The hook 22 is formed to engage the cover 20 with the casing 10. Specifically, as shown in FIG.3 and FIG.6A, the hook 22 is a plate spring hook and includes a base part (second region) 221, a manipulation part (first region) 222, and a connecting part 223. The base part 221 protrudes substantially in the thickness direction of the casing 10 from the back surface side of the end 21a of the cover body 21. The direction in which the base part 221 protrudes may not be identical to the thickness direction. The back surface side of the cover 20 is the side that faces the casing 10 when the cover 20 is attached to the casing 10. The manipulation part 222 is formed to face the base part 221. The connecting part 223 connects the base part 221 and the manipulation part 222. When the cover 20 is attached to the casing 10, the hook 22 is biased toward the engaging target part 12. The hook 22 is not limited to a plate spring hook as long as the hook 22 is biased toward the engaging target part 12 when the cover 20 is attached to the casing 10. The hook 22 may be a hook using other biasing means, such as a coil spring or a rubber.

The manipulation part 222 includes a finger-putting part (finger-putting region) 222a. In removing the cover 20 from the casing 10, the finger-putting part 222a is moved in the direction of loosening the engagement between the casing 10 and the cover 20 (in the direction from top to bottom in FIG.1).

The finger-putting part 222a has a hook shape and is formed at the free end of the manipulation part 222 opposite the end connected to the connecting part 223. As shown in FIG.3, the finger-putting part 222a has a curved shape that is depressed in the direction of loosening the engagement between the casing 10 and the cover 20 (in the direction from top to bottom in FIG.1). That is, the finger-putting part 222a is depressed in the direction opposite the arc-shaped depression of the part of the opening 11 corresponding to the finger-putting part 222a, the part of the opening 11 being provided with the engaging target part 12. The finger-putting part 222a is formed not to protrude from the outer surface of the casing 10 when the cover 20 covers the casing 10. As shown in FIG.6A, the finger-putting part 222a has a crook-shaped corner C1. The corner C1 is rounded (the sharp edge of the corner C1 is removed).

The manipulation part 222 has an engaging part (engaging region) 222b between one end connected to the connecting part 223 and the other end having the finger-putting part 222a. The engaging part 222b is formed to be engaged with the engaging target part 12 formed on the casing 10. As shown in FIG.5 and FIG.6A, the upper surface of the engaging part 222b slopes downward toward the engaging target part 12. On the upper surface of the engaging part 222b, ribs 222c are formed.

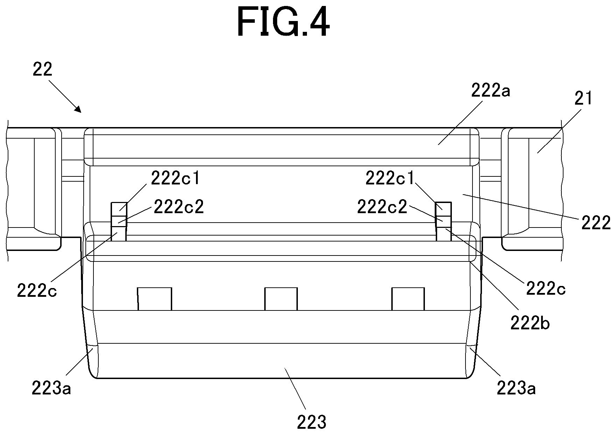

As shown in FIG.4, two ribs 222c are provided at a predetermined distance from each other in the width direction of the engaging part 222b. As shown in FIG.4 and FIG.7, each rib 222c has an engaging surface 222c1 and a sloping surface 222c2 adjacent to the lower end of the engaging surface 222c1.

As shown in FIG.7, the engaging surface 222c1 is formed to be engaged with the engaging target surface 121 of the engaging target part 12 of the casing 10. When the engaging surface 222c1 is engaged with the engaging target surface 121, namely when the cover 20 is attached to the casing 10, the manipulation part 222 is pushed toward the base part 221 by the engaging target part 12. That is, when the cover 20 is attached to the casing 10, the manipulation part 222 (hook 22) is biased toward the engaging target part 12. In the state where the engaging surfaces 222c1 of the ribs 222c are engaged with the engaging target surface 121 of the engaging target part 12, the ribs 222c prevent rattling and serve to determine the position of the cover 20 in the height direction (the thickness direction of the casing 10).

The sloping surface 222c2 slopes downward toward the engaging target part 12, as shown in FIG.7. When the engaging surfaces 222c1 are engaged with the engaging target surface 121, namely when the cover 20 is attached to the casing 10, the sloping surfaces 222c2 face the sloping surface 122 of the engaging target part 12 with a predetermined distance from the sloping surface 122.

The connecting part 223 connects the base part 221 and the manipulation part 222, as described above. As shown in FIG.6A, the connecting part 223 is U-shaped when viewed from the lateral side. The manipulation part 222, which includes the engaging part 222b, is swingable in the direction of separating from the engaging target part 12 (toward the base part 221) or in the direction toward the engaging target part 12 (separating from the base part 221) on the lowest end of the connecting part 223 as the center. The axis is the center of the connecting part 223 in the width direction of the connecting part 223. In this embodiment, the base part 221, the manipulation part 222, the engaging part 222b, and the connecting part 223 of the hook 22 have the curved shape depressed in the direction of loosening the engagement between the casing 10 and the cover 20 so as to correspond to the curved shape of the finger-putting part 222a (see FIG.3). When the finger-putting part 222a is moved in the direction of loosening the engagement between the casing 10 and the cover 20 to detach the cover 20 from the casing 10, stress tends to concentrate on both ends of the connecting part 223 in the width direction. To deal with the stress, as shown in FIG.4, chamfered parts 223a are formed on both ends of the connecting part 223 in the width direction. That is, both ends of the connecting part 223 in the width direction (in the left-right direction in FIG.1) are cut off. This reduces the concentration of stress on both ends of the connecting part 223 in the width direction.

The base part 221 protrudes from the back surface side of the inner end 21a of the cover body 21, as described above. As shown in FIG.5 and FIG.6A, the base part 221 has a chamfered part 221a at an L-shaped corner C2, which is formed by the base part 221 and the cover body 21. The chamfered part 221a is formed at a part of the base part 221 that abuts the corner C1 of the finger-putting part 222a when the finger-putting part 222a is moved in the direction of loosening the engagement between the casing 10 and the cover 20. The chamfered part 221a is formed at an angle (relief angle) corresponding to the leaning angle of the manipulation part 222 when the finger-putting part 222a abuts the base part 221. In other words, in the region (corner C2) of the base part 221 opposite the corner C1 of the finger-putting part 222a of the manipulation part 222, the chamfered part 221a is formed with a relief shape at a relief angle. The relief angle corresponds to the angle of the manipulation part 222 in contact with (abutting) the base part 221 when the finger-putting part 222a is moved in the direction of bringing the manipulation part 222 toward the base part 221. FIG.6B shows the state where the finger-putting part 222a is moved from the state of FIG.6A in the direction of bringing the manipulation part 222 toward the base part 221. The chamfered part 221a is at a position where the manipulation part 222 abuts the base part 221, and the chamfered part 221a is at an angle corresponding to the leaning angle of the manipulation part 222 abutting the base part 221. In this embodiment, the corner C1 of the finger-putting part 222a is rounded, and the chamfered part 221a is formed on the base part 221. Such a structure increases the stroke amount (moving amount) of the finger-putting part 222a even if there is not enough moving distance. Thus, the engagement between the casing 10 and the cover 20 is certainly released when the finger-putting part 222a is moved in the direction of loosening the engagement between the casing 10 and the cover 20. Herein, the rounded corner may be formed on the corner C2, and the chamfered part 221a may be formed on the manipulation part 222.

The locking parts 23 are inserted into the not-illustrated locking holes formed in the opening 11, thereby being engaged with the locking holes. Two locking parts 23 are formed on the edge of the cover body 21. Specifically, the locking parts 23 are formed on the edge of the cover body 21 such that the locking parts 23 and the hook 22 form an isosceles triangle.

The cover 20 is supported by the hook 22 and the two locking parts 23. The cover body 21, the hook 22, and the locking parts 23 are formed as one body.

In the structure described above, dry cell batteries or dry-cell-type secondary batteries are housed in a predetermined position in the opening 11, and the locking parts 23 of the cover 20 are inserted into the not-illustrated locking holes of the opening 11. In the state shown in FIG.8, by pressing the cover 20 from above, the cover body 21 of the cover 20 is fitted into the opening 11; and the hook 22 of the cover 20 bends inward to engage with the engaging target part 12. Thus, the cover 20 is fixed to the casing 10, as shown in FIG.5. In the state the cover 20 is fixed, by moving the finger-putting part 222a of the hook 22 in the direction of loosening the engagement between the casing 10 and the cover 20 (in the direction toward the base part 221), the engagement between the hook 22 and the engaging target part 12 is released, and the opening 11 is uncovered, as shown in FIG.8. Herein, since the ribs 222c each have the sloping surface 222c2 (see FIG.7), the corner of the engaging target part 12 formed by the engaging target surface 121 and the sloping surface 122 does not interfere with (does not contact) the engaging part 222b of the hook 22. Thus, the engagement between the casing 10 and cover 20 can be smoothly released.

As described above, the cover 20 of the scientific calculator 1 in the embodiment is formed to cover and uncover the opening 11 of the casing 10 and includes a hook 22. The hook 22 is formed to engage the cover 20 with the casing 10. The hook 22 includes the finger-putting part 222a that is moved in the direction of loosening the engagement between the casing 10 and the cover 20 to uncover the opening 11. The finger-putting part 222a has a curved shape depressed in the direction of loosening the engagement between the casing 10 and the cover 20. Since the finger-putting part 222a of the cover 20 of the scientific calculator 1 has a curved shape depressed in the direction of loosening the engagement between the casing 10 and the cover 20, the user can easily put his/her finger on the finger-putting part 222a. Thus, the engagement between the casing 10 and the cover 20 can be easily released.

Further, according to the cover 20 of the scientific calculator 1 in the embodiment, the hook 22 includes the base part 221 protruding from the back surface side of the cover 20; the manipulation part 222 that faces the base part 221 and includes the finger-putting part 222a and the engaging part 222b, the engaging part 222b being formed to engage with the engaging target part 12 of the casing 10; and the connecting part 223 that connects the base part 221 and the manipulation part 222. The base part 221, the engaging part 222b, the manipulation part 222, and the connecting part 223 have a curved shape depressed in the direction of loosening the engagement between the casing 10 and the cover 20 so as to correspond to the curved shape of the finger-putting part 222a. According to the above structure, the cover 20 can be easily formed.

Further, according to the cover 20 of the scientific calculator 1 in the embodiment, the hook 22 is a plate spring hook, and both ends of the connecting part 223 in the width direction are chamfered (chamfered parts 223a). Such a structure reduces the concentration of stress on both ends of the connecting part 223 in the width direction in removing the cover 20 from the casing 10.

Further, according to the cover 20 of the scientific calculator 1 in the embodiment, the finger-putting part 222a is formed not to protrude from the casing 10 in the state where the cover 20 covers the opening 11 of the casing 10. Thus, the finger-putting part 222a does not deteriorate the external appearance of the back surface side of the scientific calculator 1.

Further, the cover 20 of the scientific calculator 1 includes a cover body 21 that has a shape corresponding to the round shape of the opening 11. Thus, the design of the scientific calculator 1 can be improved.

Further, the opening 11 of the scientific calculator 1 in the embodiment has an arc shape at a position corresponding to the finger-putting part 222a, and the finger-putting part 222a has the curved shape depressed in the direction opposite the direction in which the arc shape of the opening 11 is depressed. Such a structure allows the user to easily put a finger on the finger-putting part 222a.

Although the embodiment of the present disclosure has been described in detail, the above embodiment does not limit the present disclosure and can be modified without departing from the scope of the present disclosure. For example, although the opening 11 of the casing 10 has a round shape in the above embodiment, the opening 11 is not limited to a round shape. The opening 11 may have a rectangular or oval shape, for example. If the opening 11 is rectangular, the cover body 21 has a shape corresponding to the rectangular opening 11.

In the above embodiment, the corner C1 of the finger-putting part 222a is rounded, and the chamfered part 221a is formed on the base part 221. However, as long as the corner C1 of the finger-putting part 222a is rounded, the base part 221 may not have the chamfered part 221a, for example. For another example, as long as the base part 221 has the chamfered part 221a, the corner C1 of the finger-putting part 222a may not be rounded.

In the above embodiment, the locking parts 23 of the cover 20 are fitted into not-illustrated locking holes formed at predetermined positions of the opening 11. However, the cover 20 may be coupled to the casing 10 by a hinge that allows opening and closing of the opening 11, for example. In this case, the cover 20 is not completely detached from the casing 10.

In the above embodiment, the shape of the curved surface of the sloping surface 222c2 may be matched to the shape of the movement locus of the sloping surface 222c2 when the engaging part 222b of the lid member 10 is swung. Such a structure prevents the cover 20 from moving upward by the impact on the cover 20 or the casing 10, thereby preventing the detachment of the cover 20 from the casing 10. Such a structure also allows proper disengagement of the cover 20 from the casing 10.

## Claims

1. A cover (20) formed to cover and uncover an opening (11) of a casing (10), the cover (20) comprising a hook (22) formed to engage the cover (20) with the casing (10), wherein the hook (22) includes a finger-putting part (222a) that is moved in a direction of loosening an engagement between the cover (20) and the casing (10) to uncover the opening (11), the finger-putting part (222a) has a curved shape depressed in the direction of loosening the engagement,
the hook (22) includes:
a base part (221) protruding from a back surface side of the cover (20);
a manipulation part (222) that faces the base part (221) and includes the finger-putting part (222a) and an engaging part (222b), the engaging part (222b) being formed to engage with an engaging target part (12) of the casing (10); and
a connecting part (223) that connects the base part (221) and the manipulation part (222),
the base part (221), the manipulation part (222), the engaging part (222b), and the connecting part (223) have a curved shape depressed in the direction of loosening the engagement so as to correspond to the curved shape of the finger-putting part (222a), and
the hook (22) is a plate spring hook,
**characterized in that**
both ends of the connecting part (223) in a width direction are chamfered.

2. The cover (20) according to claim 1, wherein the finger-putting part (222a) is formed not to protrude from the casing (10) in a state where the cover (20) covers the opening (11) of the casing (10).

3. An electronic device (1) comprising:
the cover (20) according to claim 1 or 2; and
the casing (10) that has the opening (11),
wherein the opening (11) is formed to house a battery.

## Patentansprüche

1. Abdeckung (20), die zum Verschließen und Freilegen einer Öffnung (11) eines Gehäuses (10) ausgebildet ist, wobei die Abdeckung (20) einen Haken (22) umfasst, der zum Herstellen von Eingriff der Abdeckung (20) mit dem Gehäuse (10) ausgebildet ist, wobei der Haken (22) einen Finger-Auflegeteil (222a) einschließt, der in einer Richtung zum Lösen eines Eingriffs zwischen der Abdeckung (20) und dem Gehäuse (10) bewegt wird, um die Öffnung (11) freizulegen, wobei der Finger-Auflegeteil (222a) eine gekrümmte Form hat, die in der Richtung zum Lösen des Eingriffs vertieft ist,
der Haken (22) einschließt:
einen Stützteil (221), der von einer Rückseite der Abdeckung (20) vorsteht;
einen Betätigungsteil (222), der dem Stützteil (221) zugewandt ist und den Finger-Auflegeteil (222a) sowie einen Eingriffsteil (222b) einschließt, wobei der Eingriffsteil (222b) so ausgebildet ist, dass er mit einem Eingriffs-Zielteil (12) des Gehäuses (10) in Eingriff kommt; und
einen Verbindungsteil (223), der den Stützteil (221) und den Betätigungsteil (222) verbindet,
wobei der Stützteil (221), der Betätigungsteil (222), der Eingriffsteil (222b) und der Verbindungsteil (223) eine gekrümmte Form haben, die in der Richtung zum Lösen des Eingriffs so vertieft ist, dass sie der gekrümmten Form des Finger-Auflegeteils (222a) entspricht, und
der Haken (22) ein Blattfeder-Haken ist,
**dadurch gekennzeichnet, dass**
beide Enden des Verbindungsteils (223) in einer Breitenrichtung abgeschrägt sind.

2. Abdeckung (20) nach Anspruch 1, wobei der Finger-Auflegeteil (222a) so ausgebildet ist, dass er in einem Zustand, in dem die Abdeckung (20) die Öffnung (11) des Gehäuses (10) abdeckt, nicht von dem Gehäuse (10) vorsteht.

3. Elektronische Vorrichtung (1), die umfasst:
die Abdeckung (20) nach Anspruch 1 oder 2; sowie
das Gehäuse (10), das die Öffnung (11) aufweist,
wobei die Öffnung (11) zum Aufnehmen einer Batterie ausgebildet ist.

## Revendications

1. Couvercle (20) formé pour couvrir et découvrir une ouverture (11) d'un boîtier (10), le couvercle (20) comprenant un crochet (22) formé pour engager le couvercle (20) au boîtier (10), dans lequel
le crochet (22) comprend une partie d'insertion de doigt (222a) qui est déplacée dans une direction de desserrage de l'engagement entre le couvercle (20) et le boîtier (10) afin de découvrir l'ouverture (11),
la partie d'insertion de doigt (222a) a une forme incurvée enfoncée dans la direction de desserrage de l'engagement,
le crochet (22) comprend :
une partie de base (221) faisant saillie depuis le côté de surface arrière du couvercle (20) ;
une partie de manipulation (222) qui fait face à la partie de base (221) et comprend la partie d'insertion de doigt (222a) et une partie d'engagement (222b), la partie d'engagement (222b) étant formée pour s'engager avec une partie cible d'engagement (12) du boîtier (10) ; et
une partie de liaison (223) qui relie la partie de base (221) et la partie de manipulation (222),
la partie de base (221), la partie de manipulation (222), la partie d'engagement (222b) et la partie de liaison (223) ont une forme incurvée enfoncée dans la direction de desserrage de l'engagement de manière à correspondre à la forme incurvée de la partie d'insertion de doigt (222a), et
le crochet (22) est un crochet à ressort à lames,
**caractérisé en ce que**
les deux extrémités de la partie de liaison (223) dans la direction de la largeur sont chanfreinées.

2. Couvercle (20) selon la revendication 1, dans lequel la partie d'insertion de doigt (222a) est formée de manière à ne pas faire saillie du boîtier (10) dans un état dans lequel le couvercle (20) couvre l'ouverture (11) du boîtier (10).

3. Dispositif électronique (1) comprenant :
le couvercle (20) selon la revendication 1 ou 2 ; et
le boîtier (10) qui a l'ouverture (11),
dans lequel l'ouverture (11) est formée pour loger une batterie.
